# EUROPEAN PATENT APPLICATION

(11) **EP 1 662 320 A1**
(43) Date of publication of application: **31.05.2006**
(21) Application number: 05257214.6
(22) Date of filing: 23.11.2005
(51) Int. Cl.: G03F 7/039, G03F 7/004

(54) **Photoresist compositions**

(30) Priority: 24.11.2004 US 631243 P
(71) Applicant: Rohm and Haas Electronic Materials, L.L.C., Marlborough, Massachusetts 01752 (US)
(72) Inventor: Cameron, James F., Cambridge Massachusetts 02139 (US); Kang, Su Jin, Grafton Massachusetts 01519 (US); Sung, Jin Wuk, Worcester Massachusetts 01605 (US)
(74) Representative: Kent, Venetia Katherine

(57) **Abstract**

Chemically-amplified positive photoresist compositions are provided that contain an additive with acetal and alicyclic groups. Preferred photoresists of the invention comprise a resin component that includes a polymer with one or more photoacid-labile moieties, one or more photoacid generator compounds, and an additive that contains one or more alicyclic groups such as adamantyl and the like.

## Description

### BACKGROUND OF THE INVENTION

### 1. Field of the Invention

This invention relates to chemically-amplified positive photoresist compositions that contain an additive with acetal and alicyclic groups. Photoresists of the invention can exhibit notably enhanced lithographic properties. Preferred photoresists of the invention comprise a resin component that includes a polymer with one or more photoacid-labile moieties, one or more photoacid generator compounds, and an additive that contains one or more alicyclic groups such as adamantyl and the like. Particularly preferred photoresist additives of the invention contain acetal photoacid-labile groups.

### 2. Background

Photoresists are photosensitive films for transfer of images to a substrate. They form negative or positive images. After coating a photoresist on a substrate, the coating is exposed through a patterned photomask to a source of activating energy such as ultraviolet light, EUV, e-beam, etc. to form a latent image in the photoresist coating. The photomask has areas opaque and transparent to activating radiation that define an image desired to be transferred to the underlying substrate. A relief image is provided by development of the latent image pattern in the resist coating. The use of photoresists is generally described, for example, by Deforest, Photoresist Materials and Processes, McGraw Hill Book Company, New York (1975), and by Moreau, Semiconductor Lithography, Principals, Practices and Materials, Plenum Press, New York (1988).

Chemically-amplified positive-acting photoresist compositions have involved cleavage of certain "blocking" groups pendant from a photoresist binder, or cleavage of certain groups that comprise a photoresist binder backbone, which cleavage provides a polar functional group, e.g. carboxyl, phenol or imide, which results in different solubility characteristics in exposed and unexposed areas of the resist coating layer. See, for example, U.S. Patents Nos. 5,075,199; 4,968,851; 4,883,740; 4,810,613; and 4,491,628, and Canadian Patent Application 2,001,384.

One approach to enhance photoresist lithographic performance of chemically amplified positive photoresists has been use of certain organic additives in addition to a deblocking resin and a photoacid generator compound. See JP2003-241383; JP2003-241376; and WO 02102759. See also U.S. Patents 6,607,870, 6,727,049, 6,767,688 and 6,743,563.

While currently available photoresists are suitable for many applications current resists also can exhibit significant shortcomings, particularly in high performance applications such as formation of highly resolved sub-quarter micron features, or other challenging features, such as a single image that contains both dense and isolated lines. As referred to herein, a developed resist line or other feature is generally considered "isolated" if it is spaced from the closest adjacent resist feature a distance equal to two or more times the line width. Thus, e.g., if a line is printed at a 0.25 µm width, that line would be considered isolated (rather than dense) if the next adjacent resist feature was spaced at least about 0.50 microns from the line. Common resolution problems with isolated lines include rounded tops and undercutting; such resolution issues can be exacerbated where isolated lines and dense lines (i.e. line that is spaced from the closest adjacent resist feature a distance equal < 2 times the line width) are formed together in the same exposure field.

It thus would be desirable to have new photoresist compositions. It would be particularly desirable to have new photoresist compositions that could exhibit enhanced lithographic performance.

### SUMMARY OF THE INVENTION

We now provide new photoresist compositions that comprise: 1) a resin component that comprises one or more polymers that comprise photoacid-labile groups; 2) one or more photoacid generator compounds; and 3) one or more organic additives that comprise one or more alicyclic groups and one or more photoacid-labile acetal groups.

More particularly, we have found that preferred photoresist compositions of the invention can exhibit enhanced resistance to oxide-based etchants, improved contrast between exposed and unexposed regions of a photoresist composition layer, and/or reduced line collapse with small features such as 100 nm lines. Photoresists of the invention also have exhibited enhanced isolated line performance relative to comparable resists that do not include an additive of the invention.

Preferred photoacid-labile additives of the invention include one or more alicyclic groups such as adamantyl, cyclohexyl, cyclopentyl, norobornyl, and the like. Alicyclic groups that include a plurality of ring groups fused or otherwise covalently linked are often preferred and may suitably comprise 2, 3 or 4 or more cyclic groups. Preferred additive compounds are relatively low molecular weight, e.g. 2,000 daltons or less, more typically about 1,500, 1000 or 800 daltons or less.

Preferred photoacid-labile additives of the invention comprise one or more acetal photoacid-labile groups. As referred to herein, the term acetal group or other similar term as its recognized meaning and is inclusive of ketals and may include groups e.g. of the formula >C(ORR')₂ where R and R' are the same or different non-hydrogen substituent including groups of the formula -O-(CXY)-O-(CX'Y')ₙ- R, wherein X, Y, X', Y' are each independently a hydrogen or non-hydrogen substituent and one or more of X, Y, X' and Y' suitably may be e.g. an aromatic group such as phenyl, alkyl e.g. C₁₋₃₀alkyl, alicyclic such as is a carbon alicyclic group e.g. optionally substituted adamantyl, and the like; n is 0 or a positive integer such as n is 0 (where no (CX'Y') groups are present) to 10; and R is ester, ether or non-hydrogen substituent such as those discussed above for X, Y, X'V', or R is an ester or ether linked to such a non-hydrogen substituent such as optionally substituted aromatic e.g. optionally substituted phenyl or optionally substituted alicyclic such as optionally substituted adamantyl. Such acetal groups may be grafted onto e.g. a phenolic or other hydroxy group (e.g. a hydroxy group of an alicyclic alcohol) or to an ester moiety. As used herein, the term acetal is inclusive of the definition for acetal provided in the IUPAC Compendium of Chemical Terminology (Blackwell Science 1997) and includes ketal groups.

Photoresist additives of the invention also may contain other moieties. For example, additives may contain nitrile units, or additional contrast enhancing groups such as an acid (-COOH) group and the like.

Preferred photoresists of the invention are positive chemically-amplified resists that comprise one or more resins that contain photoacid-labile groups such as photoacid-labile ester and/or acetal groups.

The invention also provide methods for forming relief images of the photoresists of the invention, including methods for forming highly resolved patterned photoresist images (e.g. a patterned line having essentially vertical sidewalls) of sub-quarter micron dimensions or less, such as sub-0.2 or sub-0.1 micron dimensions. The invention includes photoresists that can be imaged at a wide range of wavelengths or radiation sources, including sub-300 nm such as 24S nm and 193 nm as well as EUV, e-beam, X-ray and the like.

The invention further provides articles of manufacture comprising substrates such as a microelectronic wafer or a flat panel display substrate having coated thereon the photoresists and relief images of the invention.

The invention also provides the disclosed photoacid-labile additive compounds.

Other aspects of the invention are disclosed *infra.*

### DETAILED DESCRIPTION OF THE INVENTION

As discussed above, we now provide new photoresist compositions that comprise one or more additives that comprise alicyclic and photoacid-labile acetal groups.

Preferred photoresist additives of the invention may comprise both alicyclic (such as adamantyl, cyclohexyl norbomyl and the like) and aromatic groups (such as phenyl, naphthyl and/or acenaphthyl).

For instance, preferred photoresist additives of the invention include compounds of the following Formula (I):

(Alicyclic)-(X')-(Y')-(X)-(Acetal)-(Y)-(Arom)-(Y)-(Acetal)-(X)-(Y')-(X')-(Alicyclic) (I)

wherein:
each Alicyclic is the same or different alicyclic group preferably a carbon alicyclic group having from 3 to about 50 carbon atoms and 1 to 2, 3 or 4 or more fused or otherwise covalentiy linked rings such as cyclopentyl, cyclohexyl, adamantyl, norbornyl, isobomyl, etc.;
each Y' is independently a chemical bond or an ester group which may or may not be photoacid-labile or an ether group;
each X and X' is independently a chemical bond or a linker group such as an optionally substituted C₁₋₈alkylene, more preferably optionally substituted C₁-₄alkylene such as -(CH₂)ₙ- where p is 1 to 4;
each Acetal is independently a photoacid-labile acetal group such as those groups of the above discussed formula;
each Y may be independently a chemical bond or other linker such as an alkylene group (e.g. -(CH₂)ₙ where n is 1 to 10), and the like;
Arom is an aromatic group preferably a carbocyclic aryl group such as one or more phenyl, naphthyl and/or acenaphthyl groups. Preferred Arom groups of the above formula include phenyl groups that have hydroxy groups linked to form an acetal group e.g. linked aromatic groups having multiple hydroxy groups such as Bis-phenol, hydroxyquinone, catechol and/or resorcinol groups.

Additional suitable photoresist additives of the invention include compounds of the following Formula (II):

(Aromatic)-(Y)-(Acetal)-(Y')-(Alicyclic) (II)

wherein:
Aromatic, Alicyclic, Y and Y is the same as defined above for Formula (I).

Generally preferred photoresist additive compounds of the invention are non-polymeric, i.e. the additive compounds do not typically contain 5 or 10 or more of the same covalently linked units. Typically preferred photoresist additives are non-polymeric and do not contain more than about 4 or even three of the same covalently linked units.

Exemplary specifically preferred photoresist additives of the invention include the following:

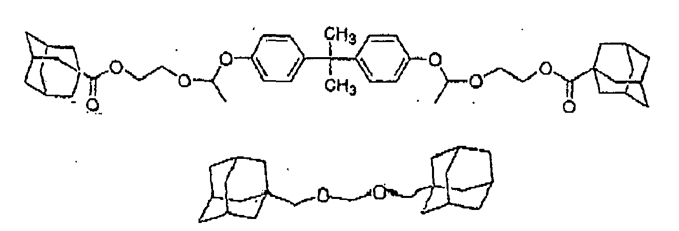

Additives of the invention can be readily produced by known synthetic methods. For instance, a reagent that contains one or more reactive group such as hydroxy or carboxy may be reacted with a vinyl ether compound suitably in the presence of an acid catalyst to provide an additive of the invention. The first reagent may be non-aromatic and e.g. contain one or more aromatic groups such as adamantyl, cyclohexyl and the like and/or contain one or more aromatic groups such as phenyl, naphthyl or acenaphthyl. Aromatic groups having hydroxy substitution are often preferred, such as phenolic groups including compounds having multiple phenyl and/or multiple hydroxy groups. For instance, optionally substituted resorcinol, catechol, hydroxyquinone and bisphenol compounds will be suitable. Exemplary bisphenol compounds including bisphenol-A, Bisphenol-E (4,4'-ethylidenebisphenol) Bis(4-hydroxyphenyl)methane, Bis(2-hydroxyphenyl)methane, Bis(3-hydroxyphenyl)methane, and the like.

The vinyl ether reagent suitably may comprise one or more alicyclic groups such as adamantyl, cyclohexyl and the like or an aromatic group such as phenyl, naphthyl or acenaphthyl. See Examples 1 and 2 which follow for exemplary preferred syntheses of photoresist additives of the invention.

Suitable amounts of an acetal additive component include at least 0.25 weight percent of the acetal additive component based on total solids (all components except solvent carrier) of a resist, more preferably at least about 0.5, 1, 2, 3, 4, 5 or 10 or more weight percent of the added acid component based on total solids (all components except solvent carrier) of a resist. It is generally not necessary and not preferred to employ one or more acetal additives in an amount in excess of about 15, 20 or 25 weight percent based on total solids (all components except solvent carrier) of a resist.

As discussed above, photoresists of the invention typically contain a resin component and a photoactive component. Photoresists of the invention preferably contain a resin that comprises one or more photoacid-acid labile moieties (e.g. ester and/or acetal groups) and one or more photoacid generator compounds (PAGs). The photoacid-lablie moiety can undergo a deblocking reaction to provide a polar functional group such as hydroxyl or carboxylate. Preferably the resin component is used in a resist composition in an amount sufficient to render the resist developable with an aqueous alkaline solution.

Preferred PAGS can be photoactivated by exposure radiation having a wavelength of 248 nm and/or 193 nm. Other suitable PAGs may be activated with other radiation such as EUV, e-beam, IPL and x-ray.

Particularly preferred photoresists of the invention contain an imaging-effective amount of one or more photoacid generator compounds and a resin suitable for imaging at 300 nm or less, such as a resin selected from the group of:
1) a phenolic resin that contains acid-labile groups that can provide a chemically amplified positive resist particularly suitable for imaging at 248 nm. Particularly preferred resins of this class include: i) polymers that contain polymerized of a vinyl phenol and an alkyl acrylate, where the polymerised alkyl acrylate units can undergo a deblocking reaction in the presence of photoacid. Exemplary alkyl acrylates that can undergo a photoacid-induced deblocking reaction include e.g. t-butyl acrylate, t-butyl methacrylate, ethyl cyclopentyl(meth)acrylate, propylphenyl methacrylate, methyladamantyl acrylate, methyl adamantyl methacrylate, and other non-cyclic alkyl and alicyclic acrylates that can undergo a photoacid-induced reaction, such as polymers in U.S. Patents 6,042.997 and 5,492,793, incorporated herein by reference ii) polymers that contain polymerized units of a vinyl phenol an optionally substituted vinyl phenyl (e.g. styrene) that does not contain a hydroxy or carboxy ring substituent, and an alkyl acrylate such as those deblocking groups described with polymers i) above, such as polymers described in U.S. Patent 6,042,997. incorporated herein by reference: and iii) polymers that contain repeat units that comprise an acetal or ketal moiety that will react with photoacid, and optionally aromatic repeat units such as phenyl or phenolic groups; such polymers have been described in U.S. Patents 5,929,176 and 6,090,526, incorporated herein by reference.
2) a resin that is substantially or completely free of phenyl or other aromatic groups that can provide a chemically amplified positive resist particularly suitable for imaging at sub-200 nm wavelengths such as 193 nm. Particularly preferred resins of this class include: i) polymers that contain polymerized units of a non-aromatic cyclic olefin (endocyclic double bond) such as an optionally substituted norbomene, such as polymers described in U.S. Patents 5,843,624, and 6,048,664, incorporated herein by reference; ii) polymers that contain alkyl acrylate units such as e.g. t-butyl acrylate, t-butyl methacrylate, methyladamantyl acrylate, ethyl cyclopentyl(meth)acrylate, propylphenyl methacrylate, methyl adamantyl methacrylate, and other non-cyclic alkyl and alicyclic acrylates, such polymers have been described in U.S.Patent 6,057,083; European Published Applications EP01008913A1 and EP00930542A1; and U.S. pending Patent Application No. 09/143,462, all incorporated herein by reference, and iii) polymers that contain polymerized anhydride units, particularly polymerized maleic anhydride and/or itaconic anhydride units, such as disclosed in European Published Application EP01008913A1 and U.S. Patent 6,048,662, both incorporated herein by reference.
3) a resin that contains repeat units that contain a hetero atom, particularly oxygen and/or sulfur, and preferable are substantially or completely free of any aromatic units. Preferably, the heteroalicyclic unit is fused to the resin backbone, and further preferred is where the resin comprises a fused carbon alicyclic unit such as provided by polymerization of a norborene group and/or an anhydride unit such as provided by polymerization of a maleic anhydride or itaconic anhydride. Such resins are disclosed in PCT/US01/14914 and U.S. application number 09/567,634.
4) a resin that contains fluorine substitution (fluoropolymer), e.g. as may be provided by polymerization of tetrafluoroethylene, a fluorinated aromatic group such as fluoro-styrene compound, and the like. Examples of such resins are disclosed e.g. in PCT/US99/21912.

Also preferred are photoresists that contain a blend of one or more resins as disclosed herein. In particular, preferred are photoresists that contain a blend of resins where at least one resin contains ester photoacid labile group and another resin contains acetal photoacid labile groups.

For imaging at wavelengths greater than 200 nm, such as 248 nm, a particularly preferred chemically amplified photoresist of the invention comprises in admixture a photoactive component of the invention and a resin that comprises a copolymer containing both phenolic and non-phenolic units. For example, one preferred group of such copolymers has acid labile groups substantially, essentially or completely only on non-phenolic units of the copolymer, particularly alkylacrylate photoacid-labile groups, i.e. a phenolic-alkyl acrylate copolymer. One especially preferred copolymer binder has repeating units x and y of the following formula: 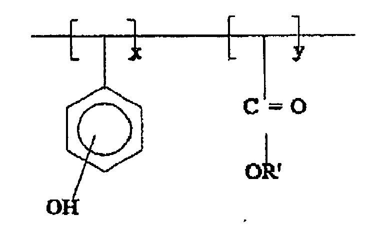 wherein the hydroxyl group be present at either the ortho, meta or para positions throughout the copolymer, and R' is substituted or unsubstituted alkyl having 1 to about 18 carbon atoms, more typically 1 to about 6 to 8 carbon atoms. *Tert*-butyl is a generally preferred R' group. An R' group may be optionally substituted by e.g. one or more halogen (particularly F, Cl or Br), C₁₋₈ alkoxy, C₂₋₈ alkenyl, etc. The units x and y may be regularly alternating in the copolymer, or maybe randomly interspersed through the polymer. Such copolymers can be readily formed. For example, for resins of the above formula, vinyl phenol and a substituted or unsubstituted alkyl acrylate such as *t*-butylacrylate and the like may be condensed under free radical conditions as known in the art. The substituted ester moiety, i.e. R'-O-C(=O)-, moiety of the acrylate units serves as the acid labile groups of the resin and will undergo photoacid induced cleavage upon exposure of a coating layer of a photoresist containing the resin. Preferably the copolymer will have a M_{w} of from about 8,000 to about 50,000, more preferably about 15,000 to about 30,000 with a molecular weight distribution of about 3 or less, more preferably a molecular weight distribution of about 2 or less. Non-phenolic resins, e.g. a copolyner nf an alkyl acrylate such as *t*-butylacrylate or t-butylmethacrylate and a vinyl alicyclic such as a vinyl norbornyl or vinyl cycloliexanol compound, also may be used as a resin binder in compositions of the invention. Such copolymers also may be prepared by such free radical polymerization or other known procedures and suitably will have a M_{w} of from about 8,000 to about 50,000, and a molecular weight distribution of about 3 or less.

The resist compositions of the invention also comprise one or more photoacid generators (i.e. "PAGs") that are suitably employed in an amount sufficient to generate a latent image in a coating layer of the resist upon exposure to activating radiation. Preferred PAGs for imaging at 193 mn and 248 nm imaging include imidosulfonates such as compounds of the following formula: 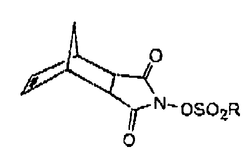 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Onium salts also preferred PAGs for use in photoresists of the invention, including iodonium and sulfonium compounds, which may be complexed with various anions including to form sulfonate salts. Two suitable agents for 193 nm and 248 nm imaging are the following PAGS 1 and 2:

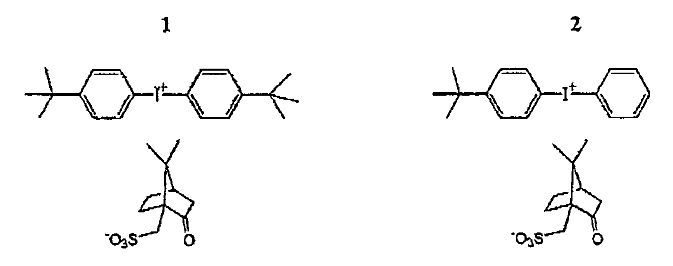

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

Other known PAGS also may be employed in the resists of the invention.

As stated above, various materials including disclosed acid additive components may be optionally substituted. A "substituted" acid additive or other material may be suitably at one or more available positions, typically 1 , 2 or 3 available positions by groups such as hydroxy, halogen, C₁₋₆alkyl, C₁₋₆alkoxy, C1-6alkylthio, C₃₋₁₈cycloalkyl, and the like.

Photoresists of the invention also may contain other materials. For example, other optional additives include actinic and contrast dyes, anti-striation agents, plasticizers, speed enhancers, sensitizers, etc. Such optional additives typically will be present in minor concentration in a photoresist composition except for fillers and dyes which may be present in relatively large concentrations such as, e.g., in amounts of from 5 to 30 percent by weight of the total weight of a resist's dry components.

A preferred optional additive of resists of the invention is an added base, particularly tetramethylammonium hydroxide (TMAH) and tetrabutylammonium hydroxide (TBAH), or more particularly the lactate salt of tetrabutylammonium hydroxide, which can enhance resolution of a developed resist relief image. The added base is suitably used in relatively small amounts, e.g. about 1 to 10 percent by weight relative to the PAG, more typically 1 to about 5 weight percent. Other preferred basic additives include ammonium sulfonate salts such as piperidinium p-toluenesulfonate and dicyclohexylammonium p-toluenesulfonate; alkyl amines such as tripropylamine and dodecylamine; aryl amines such as diphenylamine, triphenylamine, aminophenol, 2-(4-aminophenyl)-2-(4-hydroxyphenyl)propane, etc.

As discussed above, the resin component of resists of the invention are typically used in an amount sufficient to render an exposed coating layer of the resist developable such as with an aqueous alkaline solution. More particularly, a resin binder will suitably comprise 50 to about 90 weight percent of total solids of the resist. The photoactive component should be present in an amount sufficient to enable generation of a latent image in a coating layer of the resist. More specifically, the photoactive component will suitably be present in an amount of from about 1 to 40 weight percent of total solids of a resist. Typically, lesser amounts of the photoactive component will be suitable for chemically amplified resists.

The photoresists of the invention are generally prepared following known procedures. For example, a resist of the invention can be prepared as a coating composition by dissolving the components of the photoresist in a suitable solvent such as, e.g., a glycol ether such as 2-methoxyethyl ether (diglyme), ethylene glycol monomethyl ether, propylene glycol monomethyl ether; propylene glycol monomethyl ether acetate; lactates such as ethyl lactate or methyl lactate, with ethyl lactate being preferred; propionates, particularly methyl propionate, ethyl propionate and ethyl ethoxy propionate; a Cellosolve ester such as methyl Cellosolve acetate; an aromatic hydrocarbon such toluene or xylene; or a ketone such as methylethyl ketone, cyclohexanone and 2-heptanone. Typically the solids content of the photoresist varies between 5 and 35 percent by weight of the total weight of the photoresist composition.

The photoresists of the invention can be used in accordance with known procedures. Though the photoresists of the invention may be applied as a dry film, they are preferably applied on a substrate as a liquid coating composition, dried by heating to remove solvent preferably until the coating layer is tack free, exposed through a photomask to activating radiation, optionally post-exposure baked to create or enhance solubility differences between exposed and nonexposed regions of the resist coating layer, and then developed preferably with an aqueous alkaline developer to form a relief image.

The substrate on which a resist of the invention is applied and processed suitably can be any substrate used in processes involving photoresists such as a microelectronic wafer. For example, the substrate can be a silicon, silicon dioxide or aluminum-aluminum oxide microelectronic wafer. Gallium arsenide, ceramic, quartz, glass or copper substrates may also be employed. Substrates used for liquid crystal display and other flat panel display applications are also suitably employed, e.g. glass substrates, indium tin oxide coated substrates and the like.

A liquid coating resist composition may be applied by any standard means such as spinning, dipping or roller coating. Photoresists of the invention also may be formulated and applied as dry film resists, particularly for printed circuit board manufacture applications. The exposure energy should be sufficient to effectively activate the photoactive component of the radiation sensitive system to produce a patterned image in the resist coating layer. Suitable exposure energies typically range from about 1 to 300 mJ/cm2. As discussed above, preferred exposure wavelengths include sub-300 nm such as 248 nm and 193 nm. Other energy sources also may be employed such as EUV, e-beam, JPL, x-ray and the like. Suitable post-exposure bake temperatures are from about 50°C or greater, more specifically from about 50 to 140°C. For an acid-hardening negative-acting resist, a post-development bake may be employed if desired at temperatures of from about 100 to 150°C for several minutes or longer to further cure the relief image formed upon development. After development and any post-development cure, the substrate surface bared by development may then be selectively processed, for example chemically etching or plating substrate areas bared of photoresist in accordance with procedures known in the art..Suitable etchants include a hydrofluoric acid etching solution and a plasma gas etch such as an oxygen plasma etch.

All documents mentioned herein are incorporated herein by reference. The following non-limiting examples are illustrative of the invention.

### Example 1: Preparation of photoresist additive (acetal/ester type)

A reaction vessel is charged with bis-phenol A and propylene glycol methyl ether acetate to provide a 20 weight percent solution. Tracer of water are removed by azeotropic distillation. To the dried solution, 0.003 mole equivalent of trifluoroacetic acid catalyst and about a two molar equivalent of the vinyl ether having structure A immediately below are added. The reaction mixture is stirred at room temperature overnight and the additive reaction product of the immediately below structure 1 (bis-adamantyl acetal ester) is isolated by solvent removal filtration and washing. The isolated compound may be purified by chromatography and/or recrystallization if desired.

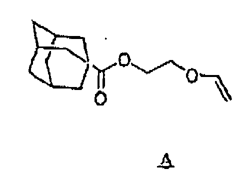

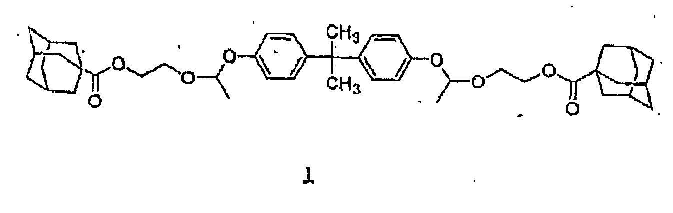

### Example 2: Preparation of photoresist additive (acetal-only (no ester) type)

A reaction vessel is charged with bis-phenol A and propylene glycol methyl ether acetate to provide a 20 weight percent solution. Traces of water are removed by azeotropic distillation. To the dried solution, 0.003 mole equivalent of trifluoroacetic acid catalyst and about a two molar equivalent of the vinyl ether having structure B immediately are added. The reaction mixture is stirred at room temperature overnight and the bis-adamantyl acetal reaction product of the immediately below structure 2 is isolated by solvent removal, filtration and washing. The isolated compound may be purified by chromatography and/or recrystallization if desired.

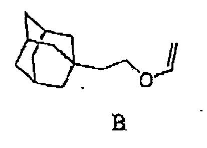

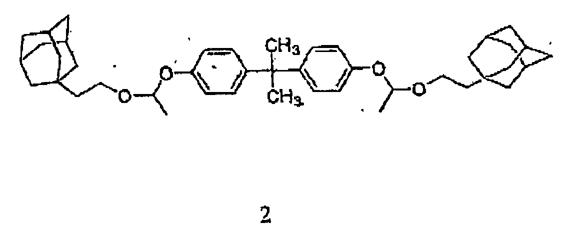

### Example 3: Photoresist preparation and lithographic processing (with comparative results),

### Control Formulation 1

This photoresist composition was prepared by admixing the following materials:
Polymer Blend of poly(hydroxystyrene/ENrE blocked hydroxystyrene/tBOC blocked hydroxystyrene) and poly(hydroxystyrene/styrene/ EVE blocked hydroxystyrene) t-Butylphenyldiphenylsulfonium perfluorobutanesulfonate, 2.8 wt % of polymer t-Butyldiazodisulfone, 3.0 wt% of polymer
Tetramethylammonium hydroxide in ethyl lactate (= Tetramethylammonium lactate in ethyl lactate), 0.183 wt % of polymer
Glycerol monolaurate, 3.0 wt % of polymer
Salicylic acid, 0.1 wt % of polymer
R-08 8 surfactant, 0.05 wt% of total solids
Propylene glycol monomethyl ether acetate (90% ) / Ethyl lactate (10%)

### Invention Formulation 1:

A photoresist was prepared by admixing the same components as the above *Control Formulation 1* but the acetal adamantyl additive 1 as prepared in Example 1 above is added to the photoresist in an amount of 5 weight percent of the polymer.

The photoresists of this Example 3 (i.e. *Control Formulation 1 and Invention Formulation 1)* were processed as follows: the resist was spin coated over an organic antireflective coating composition on a microelectronic, the coated photoresist layer softbaked at 110°C for 60 seconds to a dried thickness of 2,400A. The resist was image-wise exposed using annular illumination (0.80NA, 0.85/0,65 sigma) on a DUV scanner at 248 nm. The resist was then post exposure baked at 110°C for 60 seconds and the pattern developed in an aqueous alkaline developer solution for 60 seconds. The photoresist relief image produced with *Invention Formulation 1* showed improved resolution relative to the photoresist relief image produced with *Control Formulation 1.*

### Example 4: Photoresist preparation and lithographic processing (with comparative results)

### Control Formulation 2

This photoresist composition was prepared by admixing the following materials.
Polymer Blend of poly(hydroxystyrene/EVE blocked hydroxystyrene/iBOC blocked hydroxystyrene) and poly(hidroxystyrene/styrene/ EVE blocked hydroxystyrene)
t-Butylphenyldiphenylsulfonium perfluorobutanesulfonate (TBPDPS-PFBS), 2.8 wt % of polymer
t-Butyldiazodisulfone, 2.0 wt% of polymer
Tetramethylammonium hydroxide in ethyl lactate (= Tetramethylammonium lactate in ethyl lactate) , 0.183 wt % of polymer
Glycerol monolaurate, 3.0 wt % of polymer
Salicylic acid, 0.1 wt % of polymer
R-08 surfactant, 0.05 wt% of total solids
Propylene glycol monomethyl ether acetate (90%) / Ethyl lactate (10%)

### Invention Formulation 2:

A photoresist was prepared by admixing the same components as the above *Control Formulation 2* but the acetal adamantyl additive 1 as prepared in Example 1 above is added to the photoresist in an amount of 5 weight percent of the polymer.

The photoresists of this Example 4 were processed as described in Example 3 above. The photoresist relief image produced with *Invention Formulation 2* showed improved resolution relative to the photoresist relief image produced with *Control Formulation 2.*

### Example 5: Photoresist preparation and lithographic processing (with comparative results)

### Control Formulation 3:

This photoresist composition was prepared by admixing the following materials:
Polymer Blend of poly(hydroxystyrene/EVE blocked hydroxystyrene) and poly(hydroxysystyrene/IBE blocked hydroxystyrene)
Triphenylsulfonium perfluorobutanesulfonate (TPS-PFBS), 1.79 wt % of polymer Triphenylsulfonium camphorsulfonate (TPS-CSA), 0.84 wt % of polymer
t-Butyldiazodisulfone, 3.0 wt% of polymer
Tetramethylammonium hydroxide in ethyl lactate (= Tetramethylammonium lactate in ethyl lactate) , 0.058 wt% of polymer
Triisopropanolamine, 0.084 wt % of polymer
R-08 surfactant, 0.05 wt% of total solids
Propylene glycol monomethyl ether acetate (60% ) / Ethyl lactate (10%) / Propylene glycol monomethyl ether (30%)

### Invention formulation 3:

A photoresist was prepared by admixing the same components as the above *Control Formulation* 3 but the acetal adamantyl additive 1 as prepared in Example 1 above is added to the photoresist in an amount of 3 weight percent of the polymer.

The photoresists of this Example 5 were processed as follows: the resist was coated on SiO₂, softbaked at 100°C for 60 seconds to a dried layer thickness of 10,000 angstroms. The resist was image-wise exposed using conventional illumination (0.63NA, 0.50sigma) on a DUV stepper at 248 nm. The resist was then post exposure baked at 110°C for 60 seconds and the C/H images developed with an aqueous alkaline developer for 60 seconds. The photoresist relief image produced with *Invention Formulation 3* showed improved resolution relative to the photoresist relief image produced with *Control Formulation 3.*

The foregoing description of the invention is merely illustrative thereof, and it is understood that variations and modifications can be effected without departing from the spirit or scope of the invention as set forth in the following claims.

## Claims

1. A photoresist composition comprising:
i) a resin component that comprises one or more polymers that comprise photoacid-labile groups;
ii) one or more photoacid generator compounds; and
iii) one or more non-polymeric compounds that comprise one or more photoacid-labile acetal groups and one or more alicyclic groups.

2. The photoresist composition of claim 1 wherein the one or more non-polymeric compounds comprise adamantyl groups.

3. The photoresist composition of claim 1 wherein the one or more non-polymeric compounds comprise phenyl groups.

4. The photoresist composition of claim 1 wherein the one or more non-polymeric compounds comprise ester groups and/or ether groups.

5. The photoresist composition of claim 1 wherein one or more polymers that comprise photoacid-labile groups further comprise aromatic groups.

6. The photoresist composition of claim 1 wherein one or more polymers that comprise photoacid-labile groups is at least substantially free of aromatic groups.

7. A method for treating a substrate, comprising:
applying a layer of a photoresist composition of claim 1 on a substrate surface; and
exposing the photoresist layer to patterned radiation and developing the exposed photoresist composition layer.

8. An article of manufacture comprising a substrate having coated thereon a photoresist composition of claim 1.

9. The article of claim 8 wherein the substrate is a microelectronic semiconductor wafer substrate.

10. An additive compound that is non-polymeric and comprises one or more photoacid-labile acetal groups and one or more alicyclic groups.
